(19) **Europäisches Patentamt / European Patent Office / Office européen des brevets**

(11) **EP 4 134 684 B1**

(12) **EUROPEAN PATENT SPECIFICATION**

(45) Date of publication and mention of the grant of the patent:
**27.05.2026  Bulletin 2026/22**

(21) Application number: **21785640.0**

(22) Date of filing: **30.03.2021**

(51) International Patent Classification (IPC):
**G01R 31/54** (2020.01)　　　**G01R 31/58** (2020.01)
**G01R 31/66** (2020.01)　　　**G01D 3/08** (2006.01)
**G01R 19/165** (2006.01)　　　**G01R 31/28** (2006.01)

(52) Cooperative Patent Classification (CPC):
**G01R 31/54;** G01D 3/08; G01R 19/1659;
G01R 31/2829

(86) International application number:
**PCT/JP2021/013490**

(87) International publication number:
**WO 2021/205940 (14.10.2021 Gazette 2021/41)**

(54) **FAULT DETECTION CIRCUIT AND DETECTION SYSTEM**

FEHLERERKENNUNGSSCHALTUNG UND ERKENNUNGSSYSTEM

CIRCUIT DE DÉTECTION DE DÉFAUT ET SYSTÈME DE DÉTECTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.04.2020　JP 2020070474**

(43) Date of publication of application:
**15.02.2023　Bulletin 2023/07**

(73) Proprietor: **Minebea Mitsumi Inc.**
**Kitasaku-gun, Nagano 3890293 (JP)**

(72) Inventor: **YAMAMOTO, Kosuke**
**Tama-shi, Tokyo 206-8567 (JP)**

(74) Representative: **Dennemeyer & Associates S.A.**
**55, rue des Bruyères**
**1274 Howald (LU)**

(56) References cited:
| | |
|---|---|
| WO-A1-2016/136600 | CN-A- 104 880 143 |
| DE-A1- 102018 115 529 | JP-A- 2001 062 637 |
| JP-A- 2001 183 165 | JP-A- 2003 288 963 |
| JP-A- 2014 050 108 | JP-A- 2015 021 790 |
| JP-A- 2017 120 241 | JP-A- 2017 215 303 |
| JP-A- H04 259 831 | JP-A- H06 249 730 |
| JP-A- H1 019 957 | US-A- 5 512 890 |
| US-A1- 2006 191 889 | US-A1- 2013 207 665 |

## Description

[Technical Field]

The present invention relates to a fault detection circuit and a detection system.

[Background Art]

Patent Document 1 below discloses a disconnection detection circuit that detects a disconnection occurring at an output terminal of a bridge circuit whose intermediate voltage changes in accordance with a physical quantity that is a detection target.

Patent Document 2 below discloses a bridge type resistor strain sensor multi-mode fault detection device; under a broken line open circuit fault or a lead wire short circuit fault or a combined fault mode, a bridge type resistor strain sensor output line is pre-biased through a bias circuit; a high frequency signal is filtered by a radio frequency noise suicide circuit; the bridge type resistor strain sensor output line enters an instrument amplification circuit; the instrument amplification circuit amplifies a difference signal outputted by the bridge type resistor strain sensor; the amplified difference signal is compared with a reference voltage, set by a fault discrimination reference voltage set circuit, in a level comparison circuit, thus determining various fault modes of the bridge type resistor strain sensor; logic integration is finally realized by the line and circuit so as to output a logic signal, thus determining whether the bridge type resistor strain sensor has fault or not. The bridge type resistor strain sensor multi-mode fault detection device needs less parts, is easy to buy, low in cost, thus realizing various functions of the instrument amplifier, and effectively reducing PCB area and cost.

Patent Document 3 below discloses fault detection techniques for control of sensor systems. A sensor control integrated circuit ("IC") may include a fault detection system for coupling to the sensor supply lines. The system may detect faults for each of the sensor supply lines. The fault detection system may level shift sensor supply line signals from a first voltage domain to a second voltage domain appropriate for the fault detection system of the controller IC. The fault detection system may level shift source potential voltages from the first voltage domain to the second voltage domain to detect predetermined fault types. The fault detection system may compare the second domain voltages from the sensor supply lines to voltages representing predetermined fault types and may generate fault status indicators based on the comparison.

Patent Document 4 below discloses that to the connection point A of a sensor equipped with a bridge circuit having a side AB, a side BC, a side DC, and a side DA are applied a positive source voltage via a cable and a negative source voltage via a cable, with a positive voltage signal being outputted from a connection point B via a cable and a negative voltage signal being outputted from a connection point D via a cable. SW1-SW4 and a pulldown resistor and a pullup resistor are connected, and the comparison results of comparators are supplied to a microcomputer. The microcomputer detects the presence of abnormality and an abnormal spot using the pattern of comparison results when SW1-SW4 are turned on and off.

Patent Document 5 below discloses a sensor connection apparatus for connecting a plurality of sensors to a process controller having a bus for transferring information, wherein each sensor produces an output corresponding to a sensed condition, includes a respective sensor cable that can be connected at one end to each sensor; a concentrator having each of the sensor cables connected thereto; the concentrator being connected to the bus; the concentrator comprising a circuit for producing for each sensor and associated sensor cable connected thereto a first signal in response to the sensor output and a second signal that corresponds to a sensor cable condition; the circuit further operating to couple the first and second signals for each sensor connected to the concentrator onto the bus for access by the process controller. In one embodiment, the concentrator transmits data to the process controller using a standardized communications protocol, such as CAN, using a microcontroller and transceiver.

[Prior Art Document]

[Patent Document]

[Patent Document 1] Japanese Patent Application Publication No. 2012-008014
[Patent Document 2] Chinese Patent Application Publication No. 104 880 143
[Patent Document 3] US Patent Application Publication No. 2013/207665
[Patent Document 4] Japanese Patent Application Publication No. 2017-120241
[Patent Document 5] US Patent Publication No. 5 512 890

[Summary of the Invention]

[Problem to be Solved by the Invention]

However, the art of Patent Document 1 is configured such that when a disconnection occurs at the output terminal, the potential of the output terminal becomes the ground potential (that is, equal to or lower than a reference potential) through a resistor. Therefore, it is difficult to distinguish a disconnection fault from a case where a short circuit to the ground occurs. Therefore, it is difficult for the art of Patent Document 1 to implement various fault detections concerning connections of sensors.

[Means for Solving the Problem]

The invention is set forth in claim 1, with preferred embodiments set forth in dependent claims.

[Advantageous Effects of the Invention]

In the fault detection circuit of the invention, it is easy to implement various fault detections concerning connections of sensors.

[Brief Description of Drawings]

FIG. 1 is a diagram depicting a configuration of a detection system according to an embodiment.
FIG. 2 is a diagram depicting circuit configurations of a signal processing circuit and a fault detection circuit according to the embodiment.
FIG. 3 is a diagram depicting points for where disconnection faults can be detected by the fault detection circuit according to the embodiment.
FIG. 4 is a diagram depicting points for where short-circuit faults can be detected by the fault detection circuit according to the embodiment.

[Mode for Carrying out the Invention]

Hereinafter, an embodiment will be described with reference to the drawings.

(Configuration of Detection System 10)

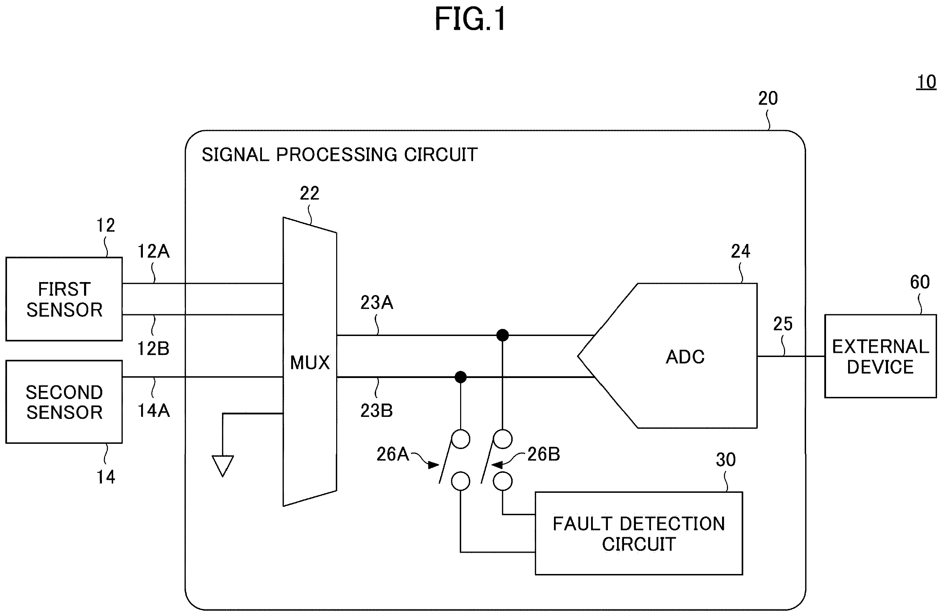

FIG. 1 is a diagram illustrating a configuration of a detection system 10 according to an embodiment. The detection system 10 depicted in FIG. 1 is capable of detecting two different types of detection targets using a first sensor 12 and a second sensor 14. As depicted in FIG. 1, there are provided the first sensor 12, the second sensor 14, and a signal processing circuit 20.

The first sensor 12 is a differential-type sensor that outputs differential signals indicating a detection result as a first detection signal. The first sensor 12 is connected to the signal processing circuit 20 through two output signal lines 12A and 12B. The first sensor 12 outputs the first detection signal (differential signals) indicating a detection result to the signal processing circuit 20 through the two output signal lines 12A and 12B.

The second sensor 14 is a single-end-type sensor that outputs a single-end-type signal indicating a detection result as a second detection signal. The second sensor 14 is connected to the signal processing circuit 20 through a single output signal line 14A. The second sensor 14 outputs the second detection signal (single-end-type signal) indicating a detection result to the signal processing circuit 20 through the single output signal line 14A.

The signal processing circuit 20 is a circuit (so-called AFE (Analog Front End)) that connects the first sensor 12 and the second sensor 14, outputting analog signals, to an external device 60, performing digital signal processing. As depicted in FIG. 1, the signal processing circuit 20 includes a multiplexer (MUX) 22, an analog-to-digital converter (ADC) 24, and a fault detection circuit 30.

The input terminals of the multiplexer 22 are connected to the two output signal lines 12A and 12B, connected to the first sensor 12, and the single output signal line 14A, connected to the second sensor 14. The multiplexer 22 is connected to two signal lines 23A and 23B which are connected to the analog-to-digital converter 24. The multiplexer 22 selectively switches between the first detection signal (the differential signals) output from the first sensor 12 and the second detection signal (single-end-type signal) output from the second sensor 14, and outputs either the first detection signal or the second detection signal to the analog-to-digital converter 24.

The input terminals of the analog-to-digital converter 24 are connected to two signal lines 23A and 23B connected to the multiplexer 22. The output terminal of the analog-to-digital converter 24 is connected to an output signal line 25 that is connected to the external device 60. The analog-to-digital converter 24 converts either the first detection signal (the differential signals) or the second detection signal (single-end-type signal) output from the multiplexer 22, from an analog signal to a digital signal; and outputs the digital signal to the external device 60. A microcomputer is used as the external device 60, for example. However, the external device 60 is not limited thereto, and any of various processing devices (for example, an IC, a personal computer, a smartphone, a tablet terminal, a server, and the like) that perform digital signal processing may be used as the external device depending on a purpose of use of the detection system 10.

The fault detection circuit 30 detects faults concerning the connections of the first sensor 12 and the second sensor 14. The fault detection circuit 30 is connected to the two signal lines 23A and 23B connected to the analog-to-digital converter 24 via two switches 26A and 26B (an example of "switching means").

When the fault detection circuit 30 is to perform fault detection, the fault detection circuit 30 is connected to the two signal lines 23A and 23B as a result of both of the two switches 26A and 26B being turned on.

On the other hand, when the fault detection circuit 30 is not to perform fault detection (that is, when the signal processing circuit 20 is used for routine duties), the fault detection circuit 30 is disconnected from the two signal lines 23A and 23B as a result of both of the two switches 26A and 26B being turned off.

(Circuit Configurations of Signal Processing Circuit 20 and Fault Detection Circuit 30)

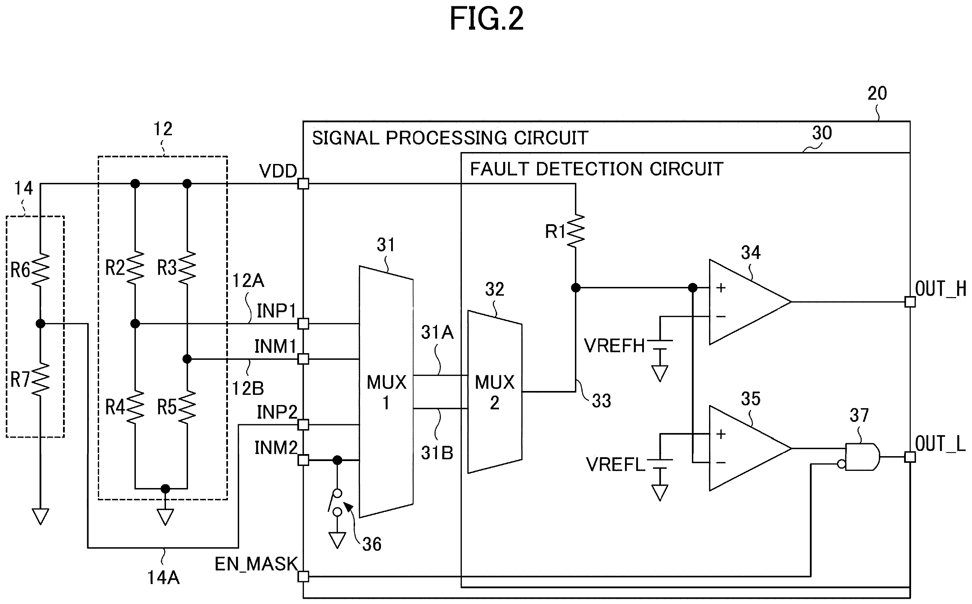

FIG. 2 is a diagram depicting circuit configurations of the signal processing circuit 20 and the fault detection circuit 30 according to the embodiment. As depicted in FIG. 2, the signal processing circuit 20 includes a power supply voltage terminal VDD, four input terminals INP1, INM1, INP2, and INM2, an input terminal EN_MASK, a first multiplexer 31, the fault detection circuit 30, and two output terminals OUT_H and OUT_L.

The fault detection circuit 30 includes a second multiplexer 32, a sensor signal line 33, a pull-up resistor R1, a first comparator 34, a second comparator 35, and an AND circuit 37.

As depicted in FIG. 2, the first sensor 12 includes four resistors R2, R3, R4, and R5 forming a bridge circuit. In the first sensor 12, the resistors R2 and R4 are connected in series with each other between the power supply voltage terminal VDD and the ground. In the first sensor 12, the output signal line 12A is connected to a point where the resistor R2 is connected with the resistor R4. In the first sensor 12, the resistors R3 and R5 are connected in series with each other between the power supply voltage VDD and the ground. In the first sensor 12, the output signal line 12B is connected to a point where the resistor R3 is connected with the resistor R5.

As depicted in FIG. 2, the second sensor 14 includes two resistors R6 and R7 connected in series with each other. In the second sensor 14, the output signal line 14A is connected to a point where the resistor R6 is connected with the resistor R7. One end of the resistor R6 is connected to the power supply voltage VDD, and the other end of the resistor R6 is connected to the resistor R7. One end of the resistor R7 is connected to the resistor R6, and the other end of the resistor R7 is connected to the ground.

Through the input terminals INP1 and INM1, input terminals of the first multiplexer 31 are connected to the two output signal lines 12A and 12B that are connected to the first sensor 12. Through the input terminal INP2, an input terminal of the first multiplexer 31 is connected to the single output signal line 14A that is connected to the second sensor 14. An input terminal of the first multiplexer 31 is connected to a spare input terminal INM2. The first multiplexer 31 selectively switches between the first detection signal (the differential signals) provided from the two signal lines 12A and 12B connected to the first sensor 12 and the second detection signal (the single-end-type signal) provided from the single signal line 14A connected to the second sensor 14, and thus, outputs either the first detection signal or the second detection signal as a signal that is regarded to detect a fault. The first multiplexer 31 of the signal processing circuit 20 depicted in FIG. 2 corresponds to the multiplexer 22 depicted in FIG. 1. The two signal lines 31A and 31B of the signal processing circuit 20 depicted in FIG. 2 correspond to the two signal lines 23A and 23B depicted in FIG. 1.

In the detection system 10 of the present embodiment, another differential-type sensor may be used instead of the second sensor 14. In this case, in the detection system 10 according to the present embodiment, two signal lines connected to the other differential-type sensor may be connected to the input terminals INP2 and INM2, and a detection signal (differential signals) may be input from the other differential-type sensor to the fault detection circuit 30 through the two signal lines.

The input terminals of the second multiplexer 32 are connected to the two output signal lines 31A and 31B that are connected to the output-terminals of the first multiplexer 31. The output terminal of the second multiplexer 32 is connected to the sensor signal line 33. The second multiplexer 32 selectively switches between the signal provided through the output signal line 31A and the signal provided through the output signal line 31B, and thus, outputs either one of these signals as a signal that is regarded to detect a fault.

By thus controlling the first multiplexer 31 and the second multiplexer 32, the fault detection circuit 30 can selectively switch between the four signals input from the input terminals INP1, INM1, INP2, and INM2, and thus, provide any one of the four signals to the sensor signal line 33 as a signal that is regarded to detect a fault. That is, the first multiplexer 31 and the second multiplexer 32 are an example of "a selecting means configured to connect any one of a plurality of input terminals, connected to the sensors, to the sensor signal line".

For example, when the first multiplexer 31 outputs the first detection signal (differential signals) as a result of switching and the second multiplexer 32 outputs the signal provided through the signal line 31A as a result of switching, one differential signal of the first detection signal (the differential signals) is provided to the sensor signal line 33.

For example, when the first multiplexer 31 outputs the first detection signal as a result of switching and the second multiplexer 32 outputs the signal provided through the signal line 31A as a result of switching, the other differential signal of the first detection signal (the differential signals) is provided to the sensor signal line 33.

For example, when the first multiplexer 31 outputs the second detection signal (the single-end-type signal) as a result of switching and the second multiplexer 32 outputs the signal provided through the signal line 31A as a result of switching, the second detection signal (the single-end-type signal) is provided to the sensor signal line 33.

For example, when the first multiplexer 31 outputs the second detection signal (the single-end-type signal) as a result of switching and the second multiplexer 32 outputs the signal provided through the output signal lines 31B as a result of switching, the spare signal input from the spare input terminal INM2 is provided to the sensor signal line 33.

Thus, one of the four signals input from the four input terminals INP1, INM1, INP2, and INM2 is provided to the sensor signal line 33 as a signal that is regarded to detect a fault. The output end of the sensor signal line 33 is connected to the non-inverting terminal (+) of the first comparator 34 and the inverting terminal (-) of the second comparator 35.

The pull-up resistor R1 is connected between the power supply voltage terminal VDD and the sensor signal line 33. The pull-up resistor R1 pulls up the potential of the sensor signal line 33 to a higher potential (a potential higher than a predetermined upper-limit threshold voltage) when a disconnection fault occurs. The pull-up resistor R1 has a resistance value (for example, 10 times or more of any one of the resistance values of the resistors R2-R7) sufficiently higher than any one of those of the resistors R2 to R7, so that the potential of the sensor signal line 33 can be increased to be higher than the upper-limit threshold voltage VREFH when any one of faults concerning the connections of the first multiplexer 31 and the second multiplexer 32 occurs, whereas the potential of the sensor signal line 33 is not appreciably affected when any one of faults concerning the connections of the first multiplexer 31 and the second multiplexer 32 does not occur.

The non-inverting terminal (+) of the first comparator 34 is connected to the sensor signal line 33. The predetermined upper-limit threshold voltage VREFH is input to the inverting terminal (-) of the first comparator 34. The output terminal of the first comparator 34 is connected to the output terminal OUT_H. The upper-limit threshold voltage VREFH has a voltage value higher than a predetermined normal voltage range.

When the voltage value of the signal that is regarded to detect a fault, input from the non-inverting terminal (+), is higher than the upper-limit threshold voltage VREFH input from the inverting terminal (-), the first comparator 34 outputs a high-level first fault detection result signal indicating that a fault concerning the connection of the first sensor 12 or the second sensor 14 occurs.

On the other hand, when the voltage value of the signal that is regarded to detect a fault, input from the non-inverting terminal (+), is lower than the upper-limit threshold voltage VREFH input from the inverting terminal (-), the first comparator 34 outputs a low-level first fault detection result signal indicating that a fault concerning the connection of the first sensor 12 or the second sensor 14 does not occur.

The inverting terminal (-) of the second comparator 35 is connected to the sensor signal line 33. A predetermined lower-limit threshold voltage VREFL is input to the non-inverting terminal (+) of the second comparator 35. The output terminal of the second comparator 35 is connected to the output terminal OUT_L via the AND circuit 37. The lower-limit threshold voltage VREFL has a voltage value lower than the predetermined normal voltage range.

When the voltage value of the signal that is regarded to detect a fault, input from the inverting terminal (-), is lower than the lower-limit threshold voltage VREFL input from the non-inverting terminal (+), the second comparator 35 outputs a high-level second fault detection result signal indicating that a fault concerning the connection of the first sensor 12 or the second sensor 14 occurs.

On the other hand, when the voltage value of the signal that is regarded to detect a fault, input from the inverting terminal (-), is higher than the lower-limit threshold voltage VREFL input from the non-inverting terminal (+), the second comparator 35 outputs a low-level second fault detection result signal indicating that a fault concerning the connection of the first sensor 12 or the second sensor 14 does not occur.

Thus, when the signal that is regarded to detect a fault is outside the predetermined normal voltage range, the fault detection circuit 30 outputs (for example, to the external device 60 depicted in FIG. 1) information indicating that a fault concerning the connection of the sensor (the first sensor 12 or the second sensor 14) that is the output source of the signal that is regarded to detect a fault, by outputting a high-level signal (the high-level first fault detection result signal or the high-level second fault detection result signal) from the first comparator 34 or the second comparator 35.

The "faults concerning the connections of the sensors" detectable by the fault detection circuit 30 are a disconnection fault (that is, an open-circuit fault) and a short-circuit fault.

(Detection of Disconnection Fault by Fault Detection Circuit)

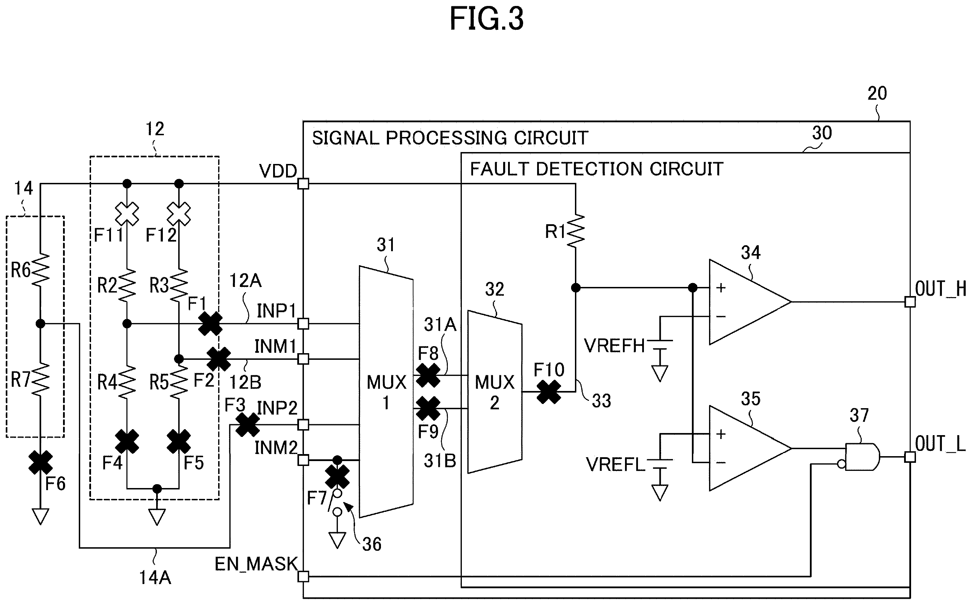

FIG. 3 is a diagram depicting disconnection fault points where faults are detectable by the fault detection circuit 30 according to the embodiment.

In FIG. 3, fault points F1 to F10 indicated by bold symbols "×" are points where the fault detection circuit 30 can detect disconnection faults; and at a time of occurrence of a disconnection fault at any of these points, the voltage value of the sensor signal line 33 is pulled up to a high potential higher than the upper-limit threshold voltage VREFH by the pull-up resistor R1 so that the high-level first fault detection result signal is output from the output terminal OUT_H.

Fault point F1: the output signal line 12A of the first sensor 12
Fault point F2: the output signal line 12B of the first sensor 12
Fault point F3: the output signal line 14A of the second sensor 14
Fault point F4: between the resistor R4 and the ground in the first sensor 12
Fault point F5: between the resistor R5 and the ground in the first sensor 12
Fault point F6: between the resistor R7 and the ground in the second sensor 14
Fault point F7: between the switch 36 and the first multiplexer 31
Fault point F8: the output signal line 31A of the first multiplexer 31
Fault point F9: the output signal line 31B of the first multiplexer 31
Fault point F10: the sensor signal line 33 (a portion before the connection point with respect to the pull-up resistor R1)

For example, in response to an occurrence of a disconnection fault at the fault point F1 on the output signal line 12A, the potential of the sensor signal line 33 is pulled up to a high potential higher than the upper-limit threshold voltage VREFH by the pull-up resistor R1 when the output signal line 12A is connected to the sensor signal line 33. As a result, a voltage higher than the upper-limit threshold voltage VREFH is input to the non-inverting terminal (+) of the first comparator 34. Thus, the first comparator 34 outputs a high-level first fault detection result signal indicating that a disconnection fault occurs on the signal line 12A.

In FIG. 3, fault points F11 and F12 indicated by outline symbols "×" are points where the fault detection circuit 30 can detect disconnection faults; and, at a time of occurrence of a disconnection fault at either one of these points, the voltage value of the sensor signal line 33 becomes "0 V" which is lower than the lower-limit threshold voltage VREFL so that a high-level second detection result signal is output from the output terminal OUT_L.

Fault point F11: between the resistor R2 and the power supply voltage VDD in the first sensor 12
Fault point F12: between the resistor R3 and the power supply voltage VDD in the first sensor 12

For example, in response to an occurrence of a disconnection fault at the fault point F11 between the resistor R2 and the power supply voltage VDD, the power supply voltage VDD comes not to be applied to the first sensor 12, but the power supply voltage VDD continues being applied to the fault detection circuit 30. Therefore, the voltage V_F11 of the sensor signal line 33 at the time of the disconnection fault at the fault point F11 can be expressed by the following formula.

$$\mathtt{V\_F11\ =\ VDD \times R5/(R1+R5)}$$

As described above, in the present embodiment, as the pull-up resistor R1, a resistor having a resistance value higher by a factor of ten times or more the resistance value of the resistor R5 is used, for example. Therefore, according to the above formula, when the resistance value of the pull-up resistor R1 is set to a sufficiently high resistance value, the voltage V_F11 of the sensor signal line 33 is substantially 0 V. Thus, the voltage "0 V" lower than the lower-limit threshold voltage VREFL is input to the inverting input terminal (-) of the second comparator 35. As a result, the second comparator 35 outputs a high-level second fault detection result signal indicating that there is a disconnection fault between the resistor R2 and the power supply voltage VDD.

In the fault detection circuit 30, it is possible to freely set a voltage range in which a fault can be detected, by freely adjusting the upper-limit threshold voltage VREFH and the lower-limit threshold voltage VREFL by, for example, setting the resistance values. As a result, in the fault detection circuit 30, it is possible to finely detect a point at which a fault occurs.

(Detection of Short-Circuit Fault by Fault Detection Circuit)

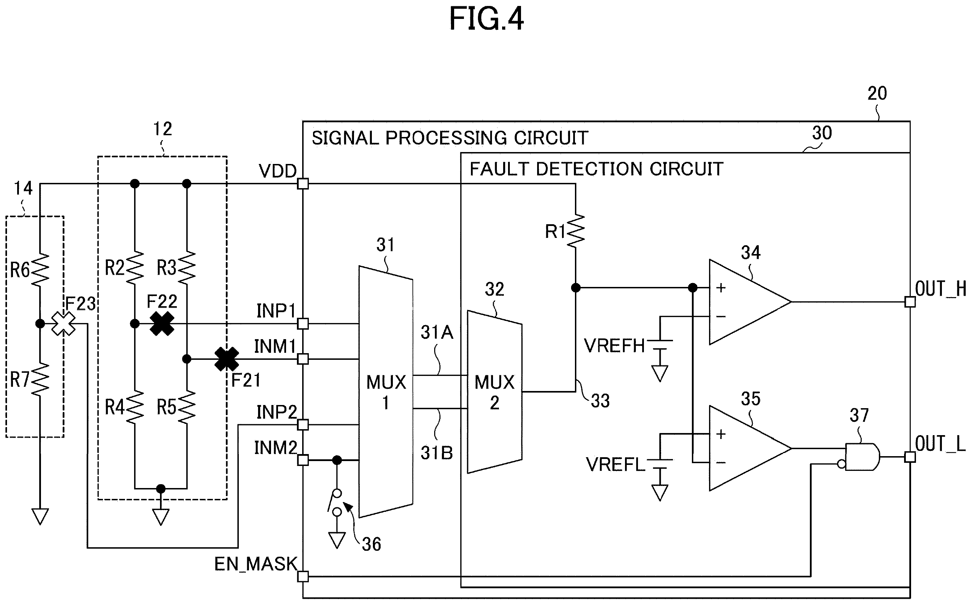

FIG. 4 is a diagram depicting short-circuit fault points where the fault detection circuit 30 can detect short-circuit faults according to the embodiment.

In FIG. 4, fault points F21 and F22 indicated by outline symbols "×" are points where short-circuit faults can be detected by the fault detection circuit 30. That is, at a time of occurrence of a short-circuit fault with respect to the power supply voltage VDD at any of these points, a high-level first fault detection result signal is output from the output terminal OUT_H. At a time of occurrence of a short-circuit fault with respect to the ground at any of these points, a high-level second fault detection result signal is output from the output terminal OUT_L.

Fault point F21: the output signal line 12A of the first sensor 12
Fault point F22: the output signal line 12B of the first sensor 12

In FIG. 4, a fault point F23 indicated by an outline symbol "×" is a point where the fault detection circuit 30 can detect a short-circuit fault with respect to the power supply voltage VDD; and, at a time of occurrence of a short-circuit fault with respect to the power supply voltage VDD at the point, a high-level fault detection result signal is output from the output terminal OUT_H.

Fault point F23: the output signal line 14A of the second sensor 14

As depicted in FIGs. 2 to 4, when a single-end-type sensor is connected to INP2 and INM2, the input terminal INM2 is in a non-connected state. In this case, the input of the first multiplexer 31 can be shortcircuited to the ground by switching the switch 36 provided between the input of the first multiplexer 31 and the ground to a turned-on state. However, in this case, the input voltage of the first multiplexer 31 is "0 V", and, therefore, if the input terminal INM2 is regarded to detect a fault, a high-level second fault detection result signal is output from the second comparator 35. In other words, it would be erroneously determined that a "fault" occurs. Therefore, in this case, in the fault detection circuit 30, the second fault detection result signal is input from the second comparator 35 to one input terminal of the AND circuit 37; and an inverted signal of a high-level masking signal, input from the input terminal EN_MASK, is input to the other input terminal of the AND circuit 37, so that masking can be implemented, and thus, a low-level second fault detection result signal can be output from the AND circuit 37 to the output terminal OUT_L.

Thus, the fault detection circuit 30 according to the embodiment includes the sensor signal line 33 connected to the sensor; the pull-up resistor R1 connected between the power supply voltage VDD and the sensor signal line 33; and the first comparator 34 having the non-inverting input terminal connected to the sensor signal line 33 and the inverting input terminal to which the predetermined upper-limit threshold voltage VREFH is input. Then, the fault detection circuit 30 according to the embodiment outputs, from the output terminal of the first comparator 34, the first fault detection result signal indicating whether or not a fault concerning the connection of the sensor occurs.

Accordingly, when a fault concerning the connection of the sensor occurs, the fault detection circuit 30 according to the embodiment can pull up the potential of the sensor signal line 33 by the pull-up resistor R1, and can output, from the output terminal of the first comparator 34, the first fault detection result signal indicating that a fault concerning the connection of the sensor occurs.

The fault detection circuit 30 according to the embodiment further includes the second comparator 35 having the inverting input terminal to which the sensor signal line 33 is connected and the non-inverting input terminal to which the predetermined lower-limit threshold voltage VREFL is input. The fault detection circuit 30 then outputs the second fault detection result signal, indicating whether or not a fault concerning the connection of the sensor occurs, from the output terminal of the second comparator 35.

As a result, when the potential of the sensor signal line 33 falls below the normal voltage range due to an occurrence of a fault concerning the connection of the sensor, the fault detection circuit 30 according to the embodiment can output the second fault detection result signal, indicating that a fault concerning the connection of the sensor occurs, from the output terminal of the second comparator 35.

The fault detection circuit 30 according to the embodiment further includes the first multiplexer 31 and the second multiplexer 32 that connect any one of the plurality of input terminals connected to the sensors to the sensor signal line 33.

As a result, the fault detection circuit 30 according to the embodiment can determine whether or not a fault concerning the connection of the sensor occurs, with respect to each of the plurality of signal lines connected to the plurality of input terminals.

The fault detection circuit 30 according to the embodiment has two input terminals per one sensor. In the fault detection circuit 30, the two output signal lines of the differential-type sensor can be connected to two input terminals, and also, the single output signal line of the single-end-type sensor can be connected to either one of two input terminals.

As a result, the fault detection circuit 30 according to the embodiment can determine whether or not a fault concerning the connection of the sensor occurs, with respect to each of the differential-type sensor and the single-end-type sensor.

Although the embodiments of the present invention have been described in detail above, the present invention is not limited to these embodiments, and various modifications or variations can be made within the scope of the present invention claimed in the claims.

For example, in the embodiment, the fault detection circuit 30 is configured to detect faults concerning the connections of the two sensors 12 and 14; but the present invention is not limited thereto, and the configuration of the embodiment may be modified to detect faults concerning the connections of three or more sensors.

[Description of Symbols]

    10 Detection system
    12 First sensor
    12A, 12B Output signal lines
    14 Second sensor
    14A Output signal line
    20 Signal processing circuit
    22 Multiplexer
    23A, 23B Signal line
    24 Analog-to-digital converter
    26A, 26B Switches (switching means)
    30 Fault detection circuit
    31 First multiplexer (selecting means)
    32 Second multiplexer (selecting means)
    33 Sensor signal line
    34 First comparator
    35 Second comparator
    36 Switch
    37 AND circuit (masking means)
    60 External device
    R1 Pull-up resistor
    INP1, INM1, INP2, INM2, EN_MASK Input terminals
    OUT_H, OUT_L Output terminals
    VDD Power supply voltage terminal

## Claims

1. A fault detection circuit (30) comprising:

   a sensor signal line (33) connected to a sensor (12, 14);
   a pull-up resistor (R1) connected between a power supply voltage (VDD) and the sensor signal line (33); and
   a first comparator (34) having a non-inverting input terminal to which the sensor signal line (33) is connected and an inverting input terminal to which a predetermined upper-limit threshold voltage (VREFH) is input,
   wherein
   a first fault detection result signal, indicating whether or not a fault concerning connection of the sensor (12, 14) occurs, is output from an output terminal of the first comparator (34),
   wherein
   the fault detection circuit (30) is configured to output the first fault detection result signal indicating that the fault concerning connection of the sensor (12, 14) occurs in response to an occurrence of a disconnection fault with respect to the sensor (12, 14),
   wherein
   the pull-up resistor (R1) is configured to increase a potential of the sensor signal line (33) to be higher than the predetermined upper-limit threshold voltage (VREFH) when the fault concerning connection of the sensor (12, 14) occurs,
   wherein
   the fault detection circuit (30) further comprises a second comparator (35) having an inverting input terminal to which the sensor signal line (33) is connected and a non-inverting input terminal to which a predetermined lower-limit threshold voltage (VREFL) is input,
   wherein
   a second fault detection result signal indicating whether or not a fault concerning connection of the sensor (12, 14) occurs is output from an output terminal of the second comparator (35),
   wherein
   the fault detection circuit (30) is configured to output the second fault detection result signal indicating that the fault concerning connection of the sensor (12, 14) occurs in response to an occurrence of a short-circuit fault with respect to the sensor (12, 14),
   wherein
   the fault detection circuit (30) further comprises a selecting means (31, 32) configured to connect any one of a plurality of input terminals (INP1, INM1, INP2, INM2), connected to the sensor (12, 14), to the sensor signal line (33),
   wherein
   two input terminals (INP1, INM1, INP2, INM2) are provided per one sensor (12, 14), and
   a connection of two output signal lines (12A, 12B) of the sensor that is a differential-type sensor (12) to the two input terminals (INP1, INM1) and a connection of a single output signal line (14A) of the sensor that is a single-end-type sensor (14) to one of the two input terminals (INP2, INM2) are enabled,
   **characterized in that**
   the fault detection circuit (30) further comprises a masking means (37) configured to, in response to the other one of the two input terminals (INM2) being connected to a ground potential by the selecting means (31, 32) inside, mask the second fault detection result signal indicating that the fault occurs with the second fault detection result signal indicating that the fault does not occur.

2. A detection system (10), comprising:

   a sensor (12, 14);
   a signal processing circuit (20) configured to perform a predetermined process on an output signal of the sensor (12, 14); and
   the fault detection circuit (30) claimed in claim 1.

3. The detection system (10) as claimed in claim 2, further comprising
   a switching means (26A, 26B) configured to break a connection between the fault detection circuit (30) and the sensor signal line (33) when the signal processing circuit (20) performs the predetermined process, and connect the fault detection circuit (30) to the sensor signal line (33) when the signal processing circuit does not perform the predetermined process.

## Patentansprüche

1. Fehlererkennungsschaltung (30), umfassend:

   eine Sensorsignalleitung (33), die mit einem Sensor (12, 14) verbunden ist;
   einen Pull-up-Widerstand (R1), der zwischen einer Stromversorgungsspannung (VDD) und der Sensorsignalleitung (33) verbunden ist; und
   einen ersten Komparator (34), der einen nicht invertierenden Eingabeanschluss, mit dem die Sensorsignalleitung (33) verbunden ist, und einen invertierenden Eingabeanschluss, in den eine vorbestimmte Obergrenzwertspannung (VREFH) eingegeben wird, aufweist,
   wobei
   ein erstes Fehlererkennungsergebnissignal, das angibt, ob ein Fehler bezüglich einer Verbindung des Sensors (12, 14) auftritt oder nicht, von einem Ausgabeanschluss des ersten Komparators (34) ausgegeben wird,
wobei
die Fehlererkennungsschaltung (30) dazu konfiguriert ist, das erste Fehlererkennungsergebnissignal, das angibt, dass der Fehler bezüglich einer Verbindung des Sensors (12, 14) auftritt, als Reaktion auf ein Auftreten eines Verbindungsabbruchfehlers in Bezug auf den Sensor (12, 14) auszugeben,
wobei
der Pull-up-Widerstand (R1) dazu konfiguriert ist, ein Potenzial der Sensorsignalleitung (33) so anzuheben, dass es höher als die vorbestimmte Obergrenzwertspannung (VREFH) ist, wenn der Fehler bezüglich einer Verbindung des Sensors (12, 14) auftritt,
wobei
die Fehlererkennungsschaltung (30) ferner einen zweiten Komparator (35) umfasst, der einen invertierenden Eingabeanschluss, mit dem die Sensorsignalleitung (33) verbunden ist, und einen nicht invertierenden Eingabeanschluss, in den eine vorbestimmte Untergrenzwertspannung (VREFL) eingegeben wird, aufweist,
wobei
ein zweites Fehlererkennungsergebnissignal, das angibt, ob ein Fehler bezüglich einer Verbindung des Sensors (12, 14) auftritt oder nicht, von einem Ausgabeanschluss des zweiten Komparators (35) ausgegeben wird,
wobei
die Fehlererkennungsschaltung (30) dazu konfiguriert ist, das zweite Fehlererkennungsergebnissignal, das angibt, dass der Fehler bezüglich einer Verbindung des Sensors (12, 14) auftritt, als Reaktion auf ein Auftreten eines Kurzschlussfehlers in Bezug auf den Sensor (12, 14) auszugeben,
wobei
die Fehlererkennungsschaltung (30) ferner Auswahlmittel (31, 32) umfasst, die dazu konfiguriert sind, einen beliebigen einer Vielzahl von Eingabeanschlüssen (INP1, INM1, INP2, INM2), die mit dem Sensor (12, 14) verbunden sind, mit der Sensorsignalleitung (33) zu verbinden,
wobei
zwei Eingabeanschlüsse (INP1, INM1, INP2, INM2) pro einen Sensor (12, 14) bereitgestellt sind, und
eine Verbindung von zwei Ausgabesignalleitungen (12A, 12B) des Sensors, der ein differenzieller Sensor (12) ist, mit den zwei Eingabeanschlüssen (INP1, INM1) und eine Verbindung einer einfachen Ausgabesignalleitung (14A) des Sensors, der ein einfachendiger Sensor (14) ist, mit einer der zwei Eingabeanschlüsse (INP2, INM2) ermöglicht werden,
**dadurch gekennzeichnet, dass**
die Fehlererkennungsschaltung (30) ferner ein Maskierungsmittel (37) umfasst, das dazu konfiguriert ist, als Reaktion darauf, dass der andere der zwei Eingabeanschlüsse (INM2) durch die Auswahlmittel (31, 32) im Inneren mit einem Massepotenzial verbunden ist, das zweite Fehlererkennungsergebnissignal, das angibt, dass der Fehler auftritt, mit dem zweiten Fehlererkennungsergebnissignal zu maskieren, das angibt, dass der Fehler nicht auftritt.

2. Erkennungssystem (10), umfassend:

einen Sensor (12, 14);
eine Signalverarbeitungsschaltung (20), die dazu konfiguriert ist, einen vorbestimmten Prozess an einem Ausgabesignal des Sensors (12, 14) durchzuführen; und
die in Anspruch 1 beanspruchte Fehlererkennungsschaltung (30).

3. Erkennungssystem (10) wie in Anspruch 2 beansprucht, ferner umfassend
ein Umschaltmittel (26A, 26B), das dazu konfiguriert ist, eine Verbindung zwischen der Fehlererkennungsschaltung (30) und der Sensorsignalleitung (33) zu unterbrechen, wenn die Signalverarbeitungsschaltung (20) den vorbestimmten Prozess durchführt, und die Fehlererkennungsschaltung (30) mit der Sensorsignalleitung (33) zu verbinden, wenn die Signalverarbeitungsschaltung den vorbestimmten Prozess nicht durchführt.

**Revendications**

1. Circuit de détection de défaut (30) comprenant :

une ligne de signal de capteur (33) connectée à un capteur (12, 14) ;
une résistance de tirage vers le haut (R1) connectée entre une tension d'alimentation (VDD) et la ligne de signal de capteur (33) ; et
un premier comparateur (34) ayant une borne d'entrée non inverseuse à laquelle la ligne de signal de capteur (33) est connectée et une borne d'entrée inverseuse à laquelle une tension de seuil supérieure prédéterminée (VREFH) est appliquée,
dans lequel
un premier signal de résultat de détection de défaut, indiquant si un défaut concernant la connexion du capteur (12, 14) se produit ou non, est délivré depuis une borne de sortie du premier comparateur (34),

dans lequel

le circuit de détection de défaut (30) est configuré pour délivrer le premier signal de résultat de détection de défaut indiquant que le défaut concernant la connexion du capteur (12, 14) se produit en réponse à la survenue d'un défaut de déconnexion vis-à-vis du capteur (12, 14),

dans lequel

la résistance de tirage vers le haut (R1) est configurée pour augmenter un potentiel de la ligne de signal de capteur (33) de manière à être supérieur à la tension de seuil supérieure prédéterminée (VREFH) lorsque le défaut concernant la connexion du capteur (12, 14) se produit,

dans lequel

le circuit de détection de défaut (30) comprend en outre un deuxième comparateur (35) ayant une borne d'entrée inverseuse à laquelle la ligne de signal de capteur (33) est connectée et une borne d'entrée non inverseuse à laquelle une tension de seuil inférieure prédéterminée (VREFL) est appliquée,

dans lequel

un deuxième signal de résultat de détection de défaut indiquant si un défaut concernant la connexion du capteur (12, 14) se produit ou non est délivré depuis une borne de sortie du deuxième comparateur (35),

dans lequel

le circuit de détection de défaut (30) est configuré pour délivrer le deuxième signal de résultat de détection de défaut indiquant que le défaut concernant la connexion du capteur (12, 14) se produit en réponse à la survenue d'un défaut de court-circuit vis-à-vis du capteur (12, 14),

dans lequel

le circuit de détection de défaut (30) comprend en outre un moyen de sélection (31, 32) configuré pour connecter l'une quelconque d'une pluralité de bornes d'entrée (INP1, INM1, INP2, INM2), connectées au capteur (12, 14), à la ligne de signal de capteur (33),

dans lequel

deux bornes d'entrée (INP1, INM1, INP2, INM2) sont prévues pour chaque capteur (12, 14), et une connexion de deux lignes de signal de sortie (12A, 12B) du capteur qui est un capteur de type différentiel (12) aux deux bornes d'entrée (INP1, INM1) et une connexion d'une seule ligne de signal de sortie (14A) du capteur qui est un capteur de type à extrémité unique (14) à l'une des deux bornes d'entrée (INP2, INM2) sont permises,

**caractérisé en ce que**

le circuit de détection de défaut (30) comprend en outre un moyen de masquage (37) configuré pour, en réponse à la connexion de l'autre des deux bornes d'entrée (INM2) à un potentiel de masse par le moyen de sélection (31, 32) en interne, masquer le deuxième signal de résultat de détection de défaut indiquant que le défaut se produit avec le deuxième signal de résultat de détection de défaut indiquant que le défaut ne se produit pas.

2. Système de détection (10), comprenant :

un capteur (12, 14) ;
un circuit de traitement de signal (20) configuré pour effectuer un traitement prédéterminé sur un signal de sortie du capteur (12, 14) ; et
le circuit de détection de défaut (30) selon la revendication 1.

3. Système de détection (10) selon la revendication 2, comprenant en outre
un moyen de commutation (26A, 26B) configuré pour interrompre une connexion entre le circuit de détection de défaut (30) et la ligne de signal de capteur (33) lorsque le circuit de traitement de signal (20) effectue le traitement prédéterminé, et connecter le circuit de détection de défaut (30) à la ligne de signal de capteur (33) lorsque le circuit de traitement de signal n'effectue pas le traitement prédéterminé.

# FIG.1

EP 4 134 684 B1

FIG.2

# FIG.3

EP 4 134 684 B1

# FIG.4

EP 4 134 684 B1

**REFERENCES CITED IN THE DESCRIPTION**

**Patent documents cited in the description**

- JP 2012008014 A
- CN 104880143
- US 2013207665
- JP 2017120241 A
- US 5512890 A